(19) Europäisches Patentamt
European Patent Office
Office européen des brevets

(11) EP 3 065 296 A1

(12) EUROPEAN PATENT APPLICATION

(43) Date of publication:
07.09.2016 Bulletin 2016/36

(51) Int Cl.:
H03K 17/0814 (2006.01)   H02M 1/088 (2006.01)
H02M 1/34 (2007.01)   H03K 17/10 (2006.01)

(21) Application number: 15275059.2

(22) Date of filing: 05.03.2015

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA

(71) Applicant: General Electric Technology GmbH
5400 Baden (CH)

(72) Inventors:
• EFIKA, Ikenna Bruce
Stafford ST16 3QE (GB)
• DAVIDSON, Colin Charnock
Stafford ST17 4PS (GB)

(74) Representative: Potter Clarkson LLP
The Belgrave Centre
Talbot Street
Nottingham NG1 5GG (GB)

(54) **Semiconductor switching string**

(57)    In the field of power converters, such as high voltage direct current (HVDC) power converters, a semiconductor switching string (10) comprises a plurality of series-connected semiconductor switching assemblies (12). Each semiconductor switching assembly (12) has a main semiconductor switching element (14) that includes first and second connection terminals (16, 18) between which current flows from the first terminal (16) to the second terminal (18) when the main semiconductor switching element (14) is switched on. The main semiconductor switching element (14) has an auxiliary semiconductor switching element (32) electrically connected between the first and second connection terminals (16, 18) thereof. The semiconductor switching string (10) also includes a local control unit (34) which is operatively connected with each auxiliary semiconductor switching element (32). The or each local control unit (34) is programmed to control switching of a respective auxiliary semiconductor switching element (32) to selectively create an alternative current path (36) between the first and second connection terminals (16, 18) associated therewith whereby current is diverted to flow through the alternative current path (36) to reduce the voltage across the corresponding main semiconductor switching element (14). The or each local control unit (34) is so programmed to selectively control switching of a respective auxiliary semiconductor switching element (32) in a fully-on mode in which the auxiliary semiconductor switching element (32) is operated with its maximum rated base current or gate voltage, and one or both of a pulsed switched mode in which the auxiliary semiconductor switching element (32) is turned on and off and an active mode in which the auxiliary semiconductor switching element (32) is operated with a continuously variable base current or gate voltage. The semiconductor switching string (10) still further includes a higher level control unit (52) that is arranged in communication with the or each local control unit (34) and is programmed to selectively implement:

(i) a first model based control methodology to collectively operate via the or each local control unit (34) each auxiliary semiconductor switching element (32) in the fully-on mode; and

(ii) a second active control based control methodology to selectively and collectively operate via the or each local control unit (34) each auxiliary semiconductor switching element (32) in one or both of the pulsed switched mode and the active mode.

Figure 1

## Description

This invention relates to a semiconductor switching string for use in a power converter, such as a high voltage direct current (HVDC) power converter.

In power transmission networks alternating current (AC) power is typically converted to direct current (DC) power for transmission via overhead lines and/or under-sea cables. This conversion removes the need to compensate for the AC capacitive load effects imposed by the transmission line or cable and reduces the cost per kilometre of the lines and/or cables, and thus becomes cost-effective when power needs to be transmitted over a long distance.

Power converters are used to convert AC power to DC power. Semiconductor switching elements, such as thyristors, are a key component of power converters, and act as controlled rectifiers to convert AC power to DC power and vice versa.

While such semiconductor switching elements have very high breakdown voltages and are capable of carrying high current loads, even semiconductor switching elements from the same batch exhibit different performance characteristics. This creates difficulties in the operation of, e.g. a power converter in which the semiconductor switching elements are incorporated.

In addition, many semiconductor switching elements have inherent limitations in their performance which require the inclusion of large, heavy and difficult-to-design remedial components within, e.g. a power converter, to compensate for these shortcomings.

According to a first aspect of the invention, there is provided a semiconductor switching string, for use in a power converter, comprising:

a plurality of series-connected semiconductor switching assemblies, each semiconductor switching assembly having a main semiconductor switching element including first and second connection terminals between which current flows from the first terminal to the second terminal when the main semiconductor switching element is switched on, the main semiconductor switching element having an auxiliary semiconductor switching element electrically connected between the first and second connection terminals thereof;

a local control unit operatively connected with each auxiliary semiconductor switching element, the or each local control unit being programmed to control switching of a respective auxiliary semiconductor switching element to selectively create an alternative current path between the first and second connection terminals associated therewith whereby current is diverted to flow through the alternative current path to reduce the voltage across the corresponding main semiconductor switching element, the or each local control unit being so programmed to selectively control switching of a respective auxiliary semiconductor switching element in a fully-on mode in which the auxiliary semiconductor switching element is operated with its maximum rated base current or gate voltage, and one or both of a pulsed switched mode in which the auxiliary semiconductor switching element is turned on and off and an active mode in which the auxiliary semiconductor switching element is operated with a continuously variable base current or gate voltage; and

a higher level control unit arranged in communication with the or each local control unit and programmed to selectively implement:

(i) a first model based control methodology to collectively operate via the or each local control unit each auxiliary semiconductor switching element in the fully-on mode; and

(ii) a second active control based control methodology to selectively and collectively operate via the or each local control unit each auxiliary semiconductor switching element in one or both of the pulsed switched mode and the active mode.

A higher level control unit that is programmed to implement a first model based control methodology is able to act quickly and without, e.g. the need for feedback on the operating status of each main semiconductor switching element, and so is able to cope well with the need, during operation of each auxiliary semiconductor switching element in its fully-on mode, to turn on and turn off each such auxiliary semiconductor switching element in a very short period of time, e.g. typically a few microseconds.

Meanwhile, the implementation of a model based control methodology also desirably allows the immediate environment in which the semiconductor string of the invention is operating, e.g. the limb portion of a converter limb in a power converter, to be taken into consideration so as to render operation of the, e.g. limb portion, stable and thereby help to ensure that operation of the remaining limb portions in the power converter also remains stable.

At the same time a higher level control unit that is programmed to implement a second active based control methodology is able to act on the basis of feedback on the status of each main semiconductor switching element to promptly and efficiently reduce any deviation in the status of respective main semiconductor switching elements via operation of the corresponding auxiliary semiconductor switching element in one or both of the pulsed switched mode and the active mode.

Preferably having the higher level control unit programmed to selectively implement a first model based control methodology includes having the higher level control unit programmed to establish when each main semiconductor switching element turns off and upon turn off of a respective main semiconductor switching element thereafter operate the corresponding auxiliary semiconductor switching element in its fully-on mode for a first time period.

Such a configuration helps to ensure that each auxiliary semiconductor switching element is operated in its fully-on mode for just long enough to counteract a voltage overshoot of the corresponding main semiconductor switching element as it turns off.

The associated coordination of the operation of the auxiliary semiconductor switching elements helps to maintain stable operation of the semiconductor switching string in which the main semiconductor switching elements are located.

Optionally having the higher level control unit programmed to establish when each main semiconductor switching element turns off includes detecting when a given main semiconductor switching element turns off by comparing the voltage thereacross with the voltage across an adjacent main semiconductor switching element.

Such an arrangement reduces communication requirements within the semiconductor switching string, while the resulting cascade effect along a whole string of series-connected main semiconductor switching elements achieves the desired detection of the switching off of each main semiconductor switching element in the string.

Comparing the voltage across a given main semiconductor switching element with the voltage across an adjacent main semiconductor switching element may include measuring the difference between the voltages and initiating operation of the auxiliary semiconductor switching element corresponding to the given main semiconductor switching element in its fully-on mode when the difference between the voltages exceeds a voltage threshold.

The foregoing helps to ensure accurate detection of when a given main semiconductor switching element switches off by exploiting the different performance characteristics of the main semiconductor switching elements which leads them to have different voltages thereacross because they begin to switch off at different times.

Alternatively having the higher level control unit programmed to establish when each main semiconductor switching element turns off may include estimating when a given main semiconductor switching element turns off according to the time elapsed since it was turned on.

Such an alternative manner of establishing the turn off of a given main semiconductor switching element is less dependent on the need for the higher level control unit to receive details of the operating status of each main semiconductor switch.

In a preferred embodiment of the invention estimating when a given main semiconductor switching element turns off includes initiating operation in its fully-on mode of the corresponding auxiliary semiconductor switching element at the estimated turn off time.

An arrangement of this type suitably coordinates operation of the various auxiliary semiconductor switching elements in a way that maintains the operating stability of the semiconductor switching string in which they are located.

Optionally having the higher level control unit programmed to operate a corresponding auxiliary semiconductor switching element in its fully-on mode for a first time period includes pre-calculating the length of the first time period.

Such pre-calculation of the length of the first time period needs to be done only once rather than continuously during each operating cycle of the semiconductor switching string, and so provides for a desired speed of operation of the first transfer function based control methodology.

Preferably pre-calculating the length of the first time period includes establishing a transfer function representative of the voltage transfer characteristics of the semiconductor switching string when operating in a blocking mode within in a limb portion of a converter limb in a power converter, with all main semiconductor switching elements in the semiconductor switching string turned off.

Such a configuration advantageously takes into account the environment in which the semiconductor switching string operates, e.g. a limb portion of a converter limb within a power converter, and so helps to ensure stable operation of the semiconductor switching string.

In another preferred embodiment of the invention establishing a transfer function includes considering the time response of the transfer function and the associated time constant with a dominant effect on a voltage overshoot of the semiconductor switching string.

Considering the time response of the transfer function and the associated time constant with a dominant effect on a voltage overshoot of the semiconductor switching string helps with the calculation of a first time period that reduces the voltage overshoot experienced by individual main semiconductor switching elements as well as optimising the peak time and rise time of such voltage overshoots.

Having the higher level control unit programmed to selectively implement a second active control based control methodology may include having the higher level control unit programmed to minimise the deviation of a measured characteristic associated with each main semiconductor switching element from a desired parameter.

Such a configuration further helps to compensate for the different performance characteristics of the various main semiconductor switching elements and thereby helps to equalise the operational burden placed on each such main semiconductor switching element.

Preferably having the higher level control unit programmed to minimise the deviation of a measured characteristic associated with each main semiconductor switching element from a desired parameter includes, for each main semiconductor switching element, generating an error signal representative of the deviation, regulating the error signal to compensate for the deviation and thereby produce a control signal, and generating a switching signal from the control signal to operate the corresponding auxiliary semiconductor switching element in one or both of the pulsed mode and the active mode.

Such an arrangement readily identifies a problem associated with a given main semiconductor switching element and efficiently corrects the said problem.

Optionally generating an error signal includes comparing the voltage across each main semiconductor switching element against a desired value.

The desired value may be one of:

an average of the voltage across a given main semiconductor switching element and the voltage across an adjacent main semiconductor switching element;
an average of the voltage across all main semiconductor switching elements in the semiconductor switching string; and
an estimated voltage.

The foregoing features help to drive the operating status of each main semiconductor switching element towards an optimum condition.

In a still further preferred embodiment of the invention regulating the error signal includes amplifying the error signal in a proportional manner.

The foregoing reliably accommodates the operational behaviour of the corresponding main semiconductor switching element and so acts to correct the problem in a stable manner.

Preferably generating a switching signal from the control signal includes one of:

utilising pulse-width modulation of constant or varying switching frequency; and
scaling the control signal.

Such a configuration repeatably and reliably produces a switching signal that operates each associated auxiliary semiconductor switching element in a reliable manner.

There now follows a brief description of preferred embodiments of the invention, by way of non-limiting example, with reference being made to the following drawings in which:

Figure 1 shows semiconductor switching string according to a first embodiment of the invention;
Figure 2 shows a semiconductor switching assembly of the semiconductor switching string shown in Figure 1;
Figure 3 illustrates a switching operation of an auxiliary semiconductor switching element of the semiconductor switching assembly shown in Figure 2;
Figure 4 illustrates schematically a first model based control methodology implemented by a higher level controller of the semiconductor switching string shown in Figure 1;
Figure 5 shows a simplified equivalent circuit which can be used to establish a voltage transfer function for the semiconductor switching string shown in Figure 1;
Figure 6 illustrates schematically a second active control based control methodology implemented by the higher level controller of the semiconductor switching string shown in Figure 1;
Figure 7(a) illustrates schematically the generation of a first switching signal by the higher level controller shown in Figure 1; and
Figure 7(b) illustrates schematically the generation of a second switching signal by the higher level controller shown in Figure 1.

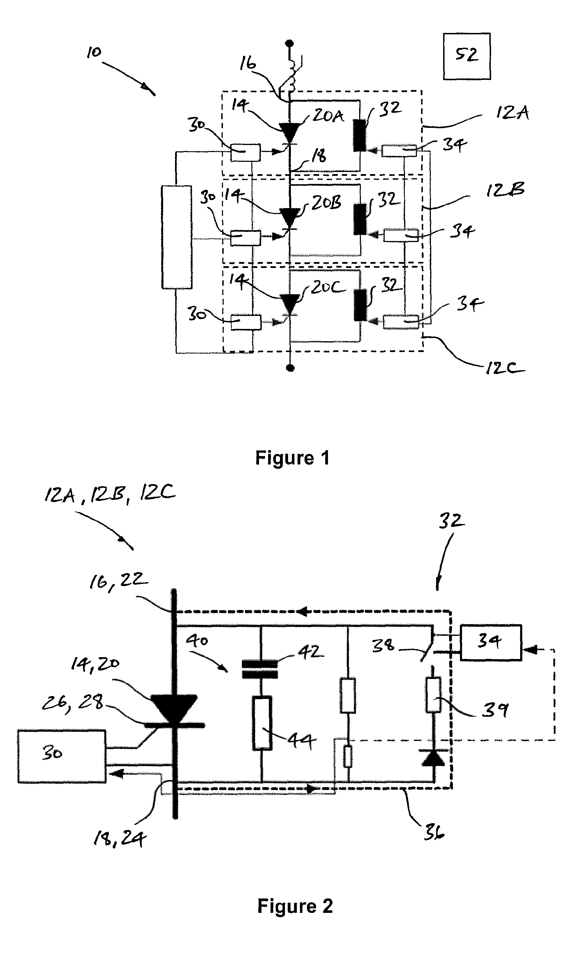

A semiconductor switching string according to a first embodiment of the invention is designated generally by reference numeral 10, as shown in Figure 1.

The semiconductor switching string 10 includes a plurality of series-connected semiconductor switching assemblies 12. Three such semiconductor switching assemblies 12A, 12B, 12C are shown in Figure 1, by way of illustration, whereas in practice the semiconductor switching string 10 is likely to include many tens or hundreds of semiconductor switching assemblies 12.

As shown in Figure 2, each semiconductor switching assembly 12 has a main semiconductor switching element 14 that includes first and second connection terminals 16, 18. In the embodiment shown the main semiconductor switching element 14 is a main thyristor 20, although in other embodiments of the invention a different semiconductor switching element may be used such as a diode, Light-Triggered Thyristor (LTT), Gate Turn-Off thyristor (GTO), Gate Commutated Thyristor (GCT) or Integrated Gate Commutated Thyristor (IGCT). Preferably the main semiconductor switching element 14 is optimised for lowest conduction (on-state) losses at the expense of other parameters such as turn-on and turn-off characteristics and off-state dv/dt capability.

The main thyristor 20 shown includes an anode 22 which defines the first connection terminal 16, a cathode 24 which defines the second connection terminal 18, and a gate 26 that defines a control terminal 28 via which the main thyristor 14 may be switched on, e.g. by a corresponding gate control unit 30.

When the main thyristor 14 is so switched on, i.e. turned-on fully, current flows through the main thyristor 14 from the first connection terminal 16 to the second connection terminal 18, i.e. from the anode 22 to the cathode 24.

The main thyristor 14 includes an auxiliary semiconductor switching element 32 which is electrically connected between the first and second connection terminals 16, 18 of the main thyristor 14, and the auxiliary semiconductor switching element 32 has a local control unit 34 that is operatively connected therewith. In the embodiment shown, each auxiliary semiconductor switching element 32 has a corresponding local control unit 34 operatively connected therewith whereas in other embodiments of the invention two or more auxiliary semiconductor switching elements 32 may share a local control unit 34.

Returning to the embodiment shown, each local control unit 34 is programmed to control switching of the corresponding auxiliary semiconductor switching element 32 to selectively create an alternative current path 36 between the first and second connection terminals 16, 18.

In the embodiment shown the auxiliary semiconductor switching element 32 is connected in inverse-parallel with the main thyristor 14 (although this need not necessarily be the case) such that when the auxiliary semiconductor switching element 32 is switched on the resulting alternative current path 36 is configured to allow current to flow from the second connection terminal 18 to the first connection terminal 16.

More particularly, the auxiliary semiconductor switching element 32 includes a transistor 38 which has a source that is connected to the first connection terminal 16 of the main thyristor 14, a drain that is connected to the second connection terminal 18 of the main thyristor 14, and a gate that is connected to the local control unit 34.

The transistor 38 shown schematically in Figure 2 is a metal-oxide-semiconductor field effect transistor (MOSFET), although many other transistors may also be used such as, for example, a bipolar junction transistor (BJT), an insulated gate bipolar transistor (IGBT), or a junction gate field-effect transistor (JFET). A transistor assembly, such as a MOSFET-JFET cascode circuit incorporating a super-cascode arrangement of 50V MOSFETs and a series string of 1200V SiC JFETs, or a direct series connection of low voltage MOSFETs or IGBTs, may also be used.

It will be appreciated that, depending on the type of transistor, one or more of the terms "source", "drain" and "gate" may be respectively replaced by the terms "emitter", "collector" and "base". By way of example, whilst a MOSFET and a JFET each has a source, drain and gate combination, an IGBT has an emitter, collector and gate combination while a BJT has an emitter, collector and base combination.

The auxiliary semiconductor switching element 32 shown in Figure 2 also includes an optional current limiting element, in the form of a resistor 39, which is connected in series with the transistor 38.

As well as having the auxiliary semiconductor switching element 32 connected in inverse-parallel therewith, the main thyristor 20 also has a passive damping circuit 40, which includes a damping capacitor 42 and a damping resistor 44, connected in parallel between the first and second connection terminals 16, 18. Other embodiments of the invention may, however, omit the passive damping circuit 40.

In use an ideal thyristor would cease to conduct exactly at the instant when the current flowing through the thyristor falls to zero. However a real thyristor, such as each of the main thyristors 20A, 20B, 20C shown in Figure 1, continues to conduct current in a reverse direction (even when the main thyristor 20 is in a so-called reverse-biased condition) for some hundreds of microseconds after the current falls to zero. The time integral of this reverse current is the 'reverse recovered charge' ($Q_{rr}$), i.e. stored charge, of the main thyristor 20A, 20B, 20C.

In the embodiment shown, a first main thyristor 20A has a lower $Q_{rr}$ than, e.g. a second main thyristor 20B in an otherwise identical second semiconductor switching assembly 12B which is connected in series with the first semiconductor switching assembly 12A that includes the first main thyristor 20A.

The aforementioned difference in $Q_{rr}$ between the first and second main thyristors 20A, 20B arises due to manufacturing tolerances/imperfections e.g. while introducing dopants into the first main thyristor 20A and the second main thyristor 20B. As a result the first main thyristor 20A will establish peak reverse current and start supporting reverse blocking voltage sooner than in the second main thyristor 20B.

When the first and second main thyristors 20A, 20B are connected in the series arrangement shown in Figure 1 the current flowing through the first semiconductor switching assembly 12A must be the same as the current flowing through the second semiconductor switching assembly 12B and thus the difference in reverse current flows through the passive damping circuit 40 of the first main thyristor. Also, since the first main thyristor 20A establishes reverse blocking voltage sooner this causes the voltage $V_A$ across the first main thyristor 20A to reach a larger reverse peak voltage, than the second main thyristor 20B with a higher $O_{rr}$.

Such operation, if left un-checked, gives rise to a voltage offset $\Delta V$ between the voltage $V_A$ across the first main thyristor 20A and the voltage $V_B$ across the second main thyristor 20B, where the voltage offset $\Delta V$ is given by:

$$\Delta V = \Delta Q_{rr} / C_d$$

where

$\Delta Q_{rr}$ is the difference in charge stored by the second main thyristor 20B and the first main thyristor 20A, and
$C_d$ is the value of the damping capacitor 42.

Such a voltage offset can persist for a long time such that it does not decay significantly before the first main thyristor 20A is turned on again approximately 120 electrical degrees later after blocking. Such a voltage offset can also significantly affect the timing point at which the voltage across a given main thyristor 20 crosses zero. This impacts on the accuracy of an extinction angle that must be established, e.g. when the main thyristors 20A, 20B, 20C form part of a HVDC power converter which is operating as an inverter and requires that the extinction angle includes a margin to accommodate such variations in stored charge.

However, in the semiconductor switching string 10 shown, each local control unit 34 is programmed to switch on the corresponding auxiliary semiconductor switching element 32, i.e. the corresponding transistor 38, while the corresponding main thyristor 20A, 20B, 20C is in the aforementioned reverse-biased condition and while a reverse current is flowing through the said main thyristor 20A, 20B, 20C, to create the corresponding alternative current path 36 and thereby divert the reverse current through the corresponding alternative current path 34. Such diversion of the reverse current through the corresponding alternative current path 36 prevents this current flowing into the associated damping circuit 40 (and so is equivalent to reducing the effective off-state impedance of the corresponding main thyristor 20A, 20B, 20C) such that the resulting voltage across the corresponding main thyristor 20A, 20B, 20C is reduced.

More particularly, each local control unit 34 is programmed to control the amount of current directed to flow through the corresponding alternative current path 36 by switching the corresponding transistor 38 within a switching operation in which the transistor 34 operates in a fully-on mode followed by a pulsed switched mode followed by an active mode during a given operating cycle of the semiconductor switching string 10, i.e. while each main semiconductor switching element 14, i.e. the main thyristors 20A, 20B, 20C, is in the reverse-biased condition.

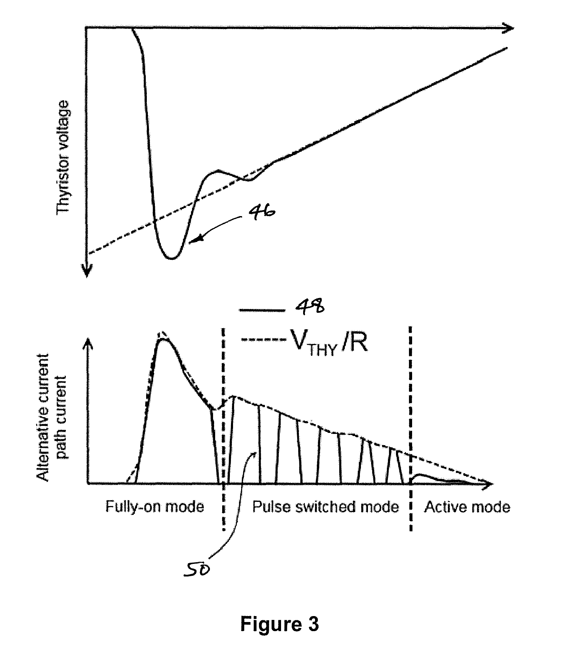

Further details of the switching operation of the transistor 34 is described as follows, with reference to Figure 3.

During the commutation overshoot transient 46 of the corresponding main thyristor 20A, 20B, 20C (i.e. when the highest amount of reverse current 48 is required to flow in the alternative current path 36), the transistor 38 is operated in the fully-on mode in which the transistor 34 is operated with its maximum rated gate voltage.

Following the operation of the transistor 38 in the fully-on mode and at intermediate values of the reverse current 48 required to flow in the alternative current path 36, the transistor 38 is operated in the pulsed switched mode in which the transistor 38 is turned on and off a plurality of times. This helps to ensure that the level of reverse current 48 flowing through the alternative current path 36, and hence the level of reverse current 48 flowing through the transistor 38, remains at a level required to compensate for the aforementioned variation in turn-off performance characteristics of the corresponding first main thyristor 20A, e.g. to compensate for a variation in $Q_{rr}$ between the main thyristors 20A, 20B, 20C.

During the pulsed switched mode, the transistor 38 is intermittently operated in the active mode in which the transistor 38 is operated with a continuously variable gate voltage. More specifically, while the transistor 38 is turned on and off during the pulsed switched mode the transistor 38 is operated in the active mode during each transition period between turned-on and turned-off states of the auxiliary semiconductor switching element, whereby the reverse current 48 flowing in the alternative current path 36 ramps up or down during each transition period. Combining the pulsed switch and active modes in this manner results in a more gradual ramp 50 of the reverse current 48 in each transition period, and thereby eliminates the problems normally associated with voltage step changes being imposed across the corresponding main thyristor 20A, 20B, 20C whilst continuing to provide the desired control over the level of reverse current 48 flowing through the alternative current path 36.

Following the pulsed switched mode, the transistor 38 is then operated in the active mode at low values of the reverse current 48 required to flow in the alternative current path 36. This provides fine control of the voltage across the corresponding main thyristor 20A, 20B, 20C, e.g. to compensate for residual voltage imbalance between the main thyristors 20A, 20B, 20C which may be caused by one or more other sources.

It will be appreciated that operation of the transistor 38 in the active mode may include operation of the transistor 38 in its linear region and/or saturation region.

In addition to the foregoing, the semiconductor switching string includes a higher level control unit 52 that is arranged in communication with each local control unit 34, and additionally with each gate control unit 30.

The higher level control unit 52 illustrated in Figure 1 is shown as being discrete from each of the local control units 34 and gate control units 30. In other embodiments of the invention, however, the or each local control unit 34 and the or each gate control unit 30 and the higher level control unit 52 may be integrally formed within a single control module (not shown). In still further embodiments of the invention the higher level control unit 52 may be implemented as a control module within a local control unit 34 or gate control unit 30.

In any event, the higher level control unit 52 is programmed to implement:

(i) a first model based control methodology to collectively operate, via each local control unit 34, each auxiliary semiconductor switching element 32 in the fully-on mode; and

(ii) a second active control based control methodology to selectively and collectively operate, again via each local control unit 34, each auxiliary semiconductor switching element 32 in both the pulsed switched mode and the active mode.

The manner in which the higher level control unit 52 is programmed to implement each of the aforementioned control methodologies is described in more detail below.

In the first instance the higher level control unit 52 may be programmed to implement a first model based control methodology such as a transfer function or state-space relationship based control methodology.

In any event, having the higher level control unit 52 programmed to selectively implement a first model based control methodology includes having the higher level control unit 52 programmed to establish when each main semiconductor switching element turns off 14, i.e. each main thyristor 20A, 20B, 20C turns off.

In addition it includes having the higher level control unit 52 programmed, upon turn off of a respective main thyristor 20A, 20B, 20C, to thereafter operate the corresponding auxiliary semiconductor switching element 32 in its fully-on mode for a first time period $t_{ON}$.

More particularly, establishing when each main thyristor 20A, 20B, 20C element turns off includes detecting when a given main thyristor 20A, 20B, 20C turns off by comparing the voltage $V_A$, $V_B$, Vc thereacross with the voltage $V_A$, $V_B$, Vc across an adjacent main thyristor 20A, 20B, 20C, i.e. another main thyristor 10A, 20B, 20C lying next to the aforesaid given main thyristor 20A, 20B, 20C in the semiconductor switching string 10.

More particularly still, comparing the voltage $V_A$, $V_B$, Vc across a given main thyristor 20A, 20B, 20C with the voltage $V_A$, $V_B$, Vc across an adjacent main thyristor 20A, 20B, 20C includes measuring the difference $d_A$, $d_B$, dc between the voltages $V_A$, $V_B$, Vc and initiating operation of the auxiliary semiconductor switching element 32 (that corresponds to the given main thyristor 20A, 20B, 20C) in its fully-on mode when the difference $d_A$, $d_B$, dc between the voltages $V_A$, $V_B$, Vc exceeds a voltage threshold 54.

In the embodiment shown, the voltage $V_A$, $V_B$, Vc across each individual main thyristor 20A, 20B, 20C is measured by the corresponding gate control unit 30 and is then passed to the local control unit 34 of the corresponding auxiliary semiconductor switching element 32, which then establishes the difference $d_A$, $d_B$, dc between the voltages $V_A$, $V_B$, Vc.

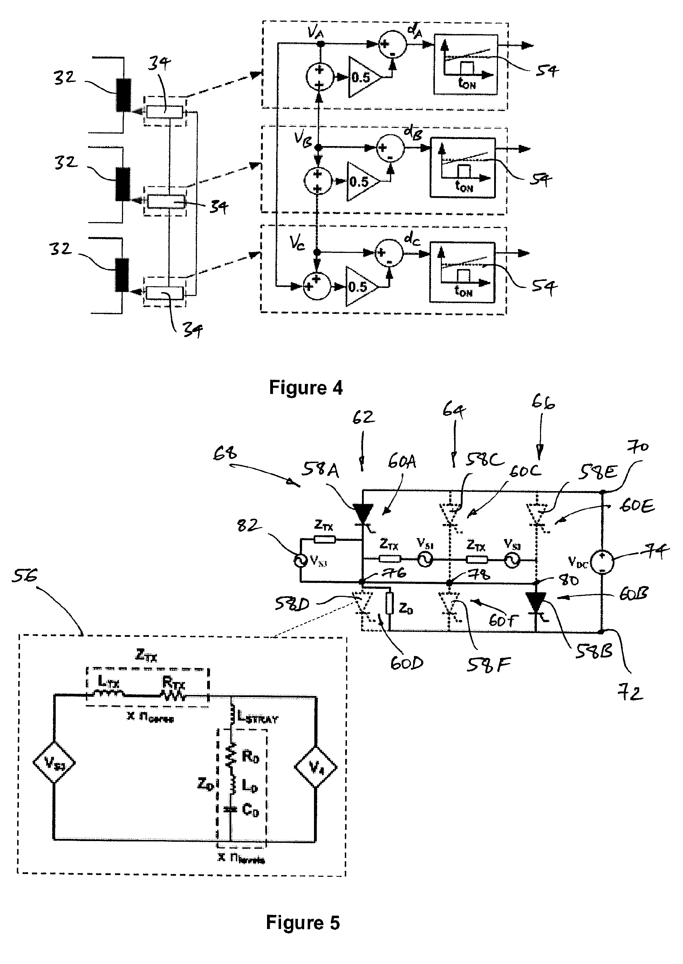

In this manner the higher level control unit 52 is programmed to delegate the step of establishing when each main thyristor 20A, 20B, 20C turns off and the step of operating the corresponding auxiliary semiconductor switching element 32 in its fully-on mode for a first time period $t_{ON}$ to each corresponding local control unit 34, i.e. as shown schematically in Figure 4.

In other embodiments of the invention the individual voltages may be obtained in a different manner and operation of each auxiliary semiconductor switching element may be done in a different way, e.g. principally by the higher level control unit 52.

In still further embodiments of the invention (not shown) having the higher level control unit 52 programmed to establish when each main thyristor 20A, 20B, 20C turns off may include estimating when a given main thyristor 20A, 20B, 20C turns off according to the time elapsed since it was turned on. In such other embodiments of the invention operation of the corresponding auxiliary semiconductor switching element 32 in its fully-on mode is initiated at the estimated turn off time.

Meanwhile, operating a corresponding auxiliary semiconductor switching element 32 in its fully-on mode for a first time period $t_{ON}$ includes pre-calculating the length of the first time period $t_{ON}$.

In the embodiment shown the higher level controller 52 is programmed to implement a first model based control methodology in the form of a transfer function control methodology, and so pre-calculating the length of the first time period $t_{ON}$ includes establishing a transfer function that is representative of the voltage transfer characteristics of the semiconductor switching string 10 when it is operating in a blocking mode within in a limb portion of a converter limb in a power converter, i.e. when the semiconductor switching string 10 lies in a said limb portion and all of the main thyristors 20A, 20B, 20C in the semiconductor switching string 10 are turned off.

In other embodiments of the invention, pre-calculating the length of the first time period $t_{ON}$ may instead include establishing a state-space representation of the voltage transfer characteristics of the semiconductor switching string 10 when it is operating in a blocking mode within in a limb portion of a converter limb in a power converter.

Returning to the embodiment shown, and by way of example, Figure 5 shows a simplified equivalent circuit 56 which can be used to model the voltage transfer characteristics of a fourth equivalent switch 58D that is defined by the semiconductor switching string 10 described hereinabove.

The fourth switch 58D is one of six essentially identical equivalent switches 58A, 58B, 58C, 58D, 58E, 58F, each of which lies within a corresponding limb portion 60A, 60B, 60C, 60D, 60E, 60F of a corresponding converter limb 62, 64, 66. The converter limbs 62, 64, 66 are arranged together in a six-pulse bridge to define a three-phase power converter 68, which extends between first and second DC terminals 70, 72 of a DC network 74 and respective AC terminals 76, 78, 80 of a three phase AC network 82. Each of the main thyristors 20A, 20B, 20C in the fourth switch 58D are turned off such that the corresponding limb portion 60D is said to be 'blocking'.

In this way the equivalent circuit 56 is able to describe to a desired extent the interaction between the damping circuit 40 within the semiconductor switching string 10 and other elements within the power converter 68.

More particularly, such interaction can be described by:

$$Z_{TX} = R_{TX} + sL_{TX}$$

$$Z_D + sL_{STRAY} = \left( R_D + sL_D + \frac{1}{sC_D} \right) n_{LEVELS} + sL_{STRAY}$$

with an associated transfer function in the complex domain being given by:

$$\frac{V_4}{V_{S3}} = \frac{Z_D + sL_{STRAY}}{Z_{TX} + Z_D + sL_{STRAY}} = \frac{\left( R_d + sL_d + \frac{1}{sC_d} \right) n_{LEVELS} + sL_{STRAY}}{R_{TX} + sL_{TX} + \left( R_d + sL_d + \frac{1}{sC_d} \right) n_{LEVELS} + sL_{STRAY}}$$

where

$V_4$ is the voltage across the fourth equivalent switch 58D, i.e. the blocking voltage supported by the semiconductor switching string 10;

$V_{S3}$ is the AC voltage at the corresponding AC terminal 76;

$Z_{TX}$ is a simplified AC network 82 and associated transformer impedance which can be represented by a series resistance $R_{TX}$ and a series inductance $L_{TX}$;

$L_{STRAY}$ is a lumped parameter representing the inductance within the corresponding limb portion 60D (which may be made up of a residual inductance of saturated reactors (not shown) within the limb portion 60D as well as any stray bus-bar inductance within the limb portion 60D);

$Z_D$ is the equivalent combined impedance made up of individual contributions from the damping circuit 40 associated with each main thyristor 20A, 20B, 20C in the semiconductor switching string (with each damping circuit 40 having an individual resistance $R_d$, i.e. the damping resistor 44, an individual capacitance $C_d$, i.e. the damping capacitor 42, and an individual inductance $L_d$); and

$n_{LEVELS}$ is the number of main thyristors 20A, 20B, 20C in the semiconductor switching string 10 (i.e. the number of damping circuits 40 in the semiconductor switching string 10).

Multiplying the numerator and denominator by s/s to eliminate the 1/s term of $C_d$ gives

$$\frac{s.R_d.n_{LEVELS} + s^2.L_d.n_{LEVELS} + \frac{n_{LEVELS}}{C_d} + s^2.L_{STRAY}}{s.R_{TX} + s^2.L_{TX} + s.R_d.n_{LEVELS} + s^2.L_d.n_{LEVELS} + \frac{n_{LEVELS}}{C_d} + s^2.L_{STRAY}}$$

and then collecting the terms in the numerator and denominator gives

$$\frac{\left(L_d n_{LEVELS} + L_{STRAY}\right)s^2 + \left(R_d n_{LEVELS}\right)s + \left(\dfrac{n_{LEVELS}}{C_d}\right)}{\left(L_{TX} + L_d n_{LEVELS} + L_{STRAY}\right)s^2 + \left(R_{TX} + R_d . n_{LEVELS}\right)s + \left(\dfrac{n_{LEVELS}}{C_d}\right)}$$

Dividing and rearranging to get unity co-efficient for $s^2$, and using
$R_D = R_d . n_{LEVELS}$;
$L_D = L_d . n_{LEVELS}$; and
$C_D = C_d / n_{LEVELS}$
gives a final transfer function of the form:

$$\frac{\left(\dfrac{L_D + L_{STRAY}}{L_{TX} + L_D + L_{STRAY}}\right)\left(s^2 + s\dfrac{R_D}{L_D + L_{STRAY}} + \dfrac{1}{C_D\left(L_D + L_{STRAY}\right)}\right)}{s^2 + s\left(\dfrac{R_{TX} + R_D}{L_{TX} + L_D + L_{STRAY}}\right) + \left(\dfrac{1}{\left(L_{TX} + L_D + L_{STRAY}\right)C_D}\right)}$$

Thereafter the higher level control unit 52 considers the time response of the above-derived transfer function and the associated time constant with a dominant effect on a voltage overshoot of the semiconductor switching string 10.
More particularly, the higher level control unit 52 is programmed to compare the above-derived transfer function with a standard transfer function of the form

$$\frac{K_b\left(1 + T_1 s\right)\left(1 + T_2 s\right)...\left(1 + T_n s\right)}{\left(1 + T_a s\right)\left(1 + T_b s\right)...\left(1 + T_m s\right)}$$

in order to focus on the gain $K_b$ and time constants $T_1$, $T_2$, $...T_n$ of the transfer function describing the behaviour of the semiconductor switching string 10 of the invention.
As an alternative, in other embodiments of the invention, the above-derived transfer function may instead be compared with a standard transfer function of the form

$$\frac{\omega_n^2}{s^2 + 2\zeta\omega_n s + \omega_n^2}$$

where:

$\omega_n$ describes the undamped natural frequency of the semiconductor switching string 10; and
$\zeta$ is a damping factor (i.e. a measure of how damped the response of the semiconductor switching string 10 is).

Returning to the comparison first mentioned above, the gain $K_b$ is given by

$$K_b = \left(\frac{L_D + L_{STRAY}}{L_{TX} + L_D + L_{STRAY}}\right)$$

while the time constants $T_1$, $T_2$, $...T_n$ are obtained as follows:

$$f(s) = s^2 + s\frac{R_D}{L_D + L_{STRAY}} + \frac{1}{C_D(L_D + L_{STRAY})}$$

with the assumption that

$$f(s) = (s+a)(s+b)....(s+c)$$

where,
a, b, c are the roots of the expression for f(s) that indicate zeros for the derived transfer function,
such that

$$T_1 = \frac{1}{a}; T_2 = \frac{1}{b}; T_n = \frac{1}{c}$$

The time response (t) of a transfer function may be expressed by considering the zeros of the transfer function, such that

$$f(t) = K_b\left(e^{-\frac{t}{T_1}} + e^{-\frac{t}{T_2}} + ....e^{-\frac{t}{T_n}}\right)$$

It follows that the zero with a dominant effect on the voltage overshoot of the semiconductor switching string 10 as a whole, indeed with the most dominant effect on the said voltage overshoot, is the zero with the smallest time constant $T_1$, $T_2$, ... $T_n$.

In the embodiment described the smallest time constant is taken as $T_1$ such that the calculated duration of the first time period $t_{ON}$, i.e. the period of time for which each auxiliary switching element 32 is operated in its fully-on mode, is given by

$$t_{ON} = 1/T_1$$

In the second instance, having the higher level control unit 52 programmed to selectively implement a second active control based control methodology includes having the higher level control unit 52 programmed to minimise the deviation of a measured characteristic associated with each main semiconductor switching element, i.e. each main thyristor 20A, 20B, 20C, from a desired parameter.

In this manner the higher level control unit 52 is programmed to implement a second active control based control methodology in the form of a servo control based control methodology, and more particularly a proportional servo control based control methodology.

Other active control based control methodologies, such as differential control and integral control, may also be used however.

In the embodiment shown, the higher level control unit 52 is programmed to eliminate the deviation of the measured characteristic associated with each main thyristor 20A, 20B, 20C from the desired parameter, and more particularly is programmed, for each main thyristor 20A, 20B, 20C, to:

generate an error signal $e_A$, $e_B$, ec representative of the deviation;
regulate the error signal $e_A$, $e_B$, ec to compensate for the deviation and thereby produce a control signal $m_{refA}$, $m_{refB}$, $m_{refC}$; and
generate a switching signal $V_{GS}$, i.e. a gate voltage for the gate of the corresponding auxiliary switching element 32, from the control signal $m_{refA}$, $m_{refB}$, $m_{refC}$ to operate the corresponding auxiliary semiconductor switching element 32 in each of the pulsed mode and the active mode.

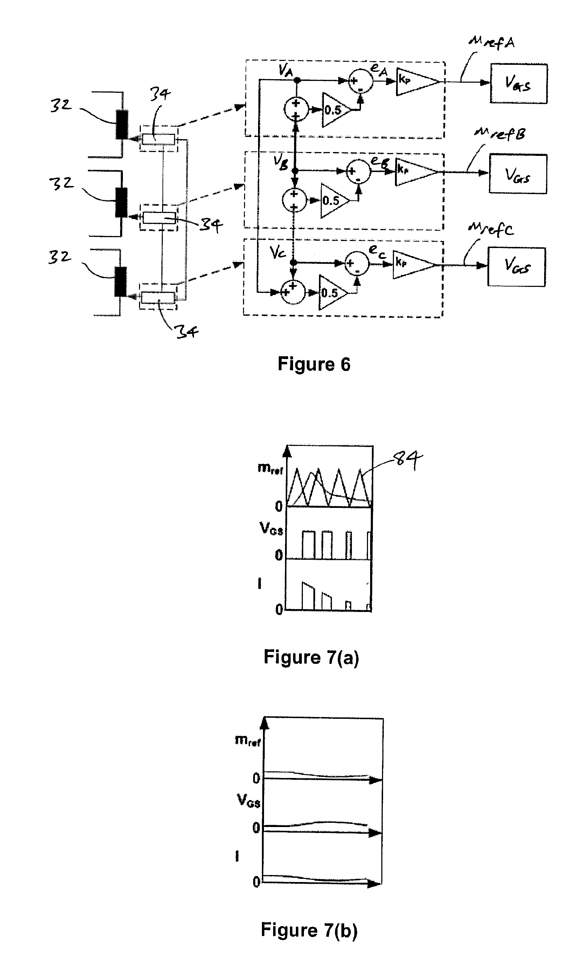

More particularly still, the higher level controller 52 is programmed to delegate the aforementioned steps to each corresponding local control unit 34, as illustrated schematically in Figure 6. In other embodiments of the invention, however, this need not necessarily be the case.

In the embodiment shown, each local control unit 34 generates an error signal $e_A$, $e_B$, ec by comparing the voltage $V_A$, $V_B$, Vc across each main thyristor 20A, 20B, 20C against a desired value in the form of an average of the voltage across a given main thyristor 20A, 20B, 20C and the voltage across an adjacent main thyristor 20A, 20B, 20C.

In other embodiments of the invention the desired value may be an average of the voltage across all main thyristors 20A, 20B, 20C in the semiconductor switching string 10, or an estimated voltage such as might be obtained by mathematical estimation or calculation.

In still further embodiments of the invention (not shown), each local control unit 34 (or the higher level control unit 52) may generate an error signal by comparing the damping current, i.e. the current flowing through the passive damping circuit 40, with a desired reference current, or by comparing the impedance of the auxiliary semiconductor switching element 32 with a desired reference impedance.

In the meantime, returing to the embodiment shown, each local control unit 34 regulates the error signal eA, $e_B$, $e_C$ by amplifying the error signal $e_A$, $e_B$, $e_C$ in a proportional manner.

Each local control unit 34 achieves this by applying a proportional gain $k_P$ to the error signal $e_A$, $e_B$, $e_C$.

Such a proportional gain $k_P$ may be selected by using trial and error with the gain value $k_P$ chosen and adjusted until the semiconductor switching string 10 exhibits desired behaviour.

The proportional gain $k_P$ may also be selected by considering a mathematical model of the semiconductor switching string 10, e.g. as defined by a transfer function.

For example, since the behaviour of the fourth equivalent switch 58D, i.e. the semiconductor switching string 10 including a passive damping circuit 40 is known, this can be used as basis for selecting the proportional gain $k_P$, such that:

$$k_P = \frac{1}{R_d I_{D\_BASE}}$$

where

$R_d$ is the damping resistance, i.e. the damping resistor 44; and

$I_{D\_BASE}$ is the peak current that flows in the passive damping circuit 40.

In addition to the foregoing, each local control unit 34 generates a switching signal $V_{GS}$ from the control signal $m_{refA}$, $m_{refB}$, $m_{refC}$, when operating the corresponding auxiliary semiconductor switching element 32 in its pulsed switched mode, by using pulse-width modulation, as shown in Figure 7(a).

More particularly, each local control unit 34 compares the control signal $m_{refA}$, $m_{refB}$, $m_{refC}$ against a carrier-type waveform 84, such as a triangular or sawtooth waveform so as to provide a switching signal $V_{GS}$ with switching pulses of a constant period T given by

$$T = t_{ON} + t_{OFF}$$

where the duty cycle, i.e.

$$t_{ON}/T$$

is varied in proportion with the control signal $m_{refA}$, $m_{refB}$, $m_{refC}$ to achieve compensation, i.e. to diminish the error.

Accordingly, for a period when the voltage $V_A$ of the first thyristor 20A is greater than the voltage $V_B$ of the second thyristor 20B, the error signal $e_A$ is given by

$$e_A = \frac{V_A - V_B}{2}$$

and the control signal $m_{refA}$ is given by

$$m_{refA} = \frac{V_A - V_B}{R_d I_{D\_BASE}}$$

The resulting control action is such that as the error $e_A$ between the compared thyristor voltages $V_A$, $V_B$ increases, the control signal $m_{refA}$ increases. This switches the auxiliary semiconductor switching element 32 on for longer when switching signal $V_{GS}$ generation is carried out, i.e. the auxiliary semiconductor switching element 32 and associated impedance, i.e. as provided by the current limiting resistor 39 therein, is left in circuit for longer with the consequence of reducing the voltage difference until the error $e_A$ is eliminated.

In another embodiment of the invention (not shown), each local control unit 34 (or the higher level control unit 52) may additionally vary the switching frequency of the corresponding auxiliary semiconductor switching element 32. Such a step might be carried out in order to optimize any losses in the said corresponding auxiliary semiconductor switching element 32. For instance the switching frequency may be reduced when the voltage $V_A$, $V_B$, $V_C$ across the corresponding main thyristor 20A, 20B, 20C is high and increased when the voltage $V_A$, $V_B$, $V_C$ is low.

Meanwhile, when operating the corresponding auxiliary semiconductor switching element 32 in its active mode, each local control unit 34 generates a switching signal $V_{GS}$ by scaling the control signal $m_{refA}$, $m_{refB}$, $m_{refC}$, as shown in Figure 7(b). Such a configuration means that a high control signal $m_{refA}$, $m_{refB}$, $m_{refC}$ results in a low switching signal $V_{GS}$, and thus a high impedance in the alternative current path 36, i.e. as provided by the corresponding auxiliary semiconductor switching element 32, and more particularly the impedance included therewithin by way of the resistor 39, being switched into circuit.

## Claims

1. A semiconductor switching string, for use in a power converter, comprising:

    a plurality of series-connected semiconductor switching assemblies, each semiconductor switching assembly having a main semiconductor switching element including first and second connection terminals between which current flows from the first terminal to the second terminal when the main semiconductor switching element is switched on, the main semiconductor switching element having an auxiliary semiconductor switching element electrically connected between the first and second connection terminals thereof;
    a local control unit operatively connected with each auxiliary semiconductor switching element, the or each local control unit being programmed to control switching of a respective auxiliary semiconductor switching element to selectively create an alternative current path between the first and second connection terminals associated therewith whereby current is diverted to flow through the alternative current path to reduce the voltage across the corresponding main semiconductor switching element, the or each local control unit being so programmed to selectively control switching of a respective auxiliary semiconductor switching element in a fully-on mode in which the auxiliary semiconductor switching element is operated with its maximum rated base current or gate voltage, and one or both of a pulsed switched mode in which the auxiliary semiconductor switching element is turned on and off and an active mode in which the auxiliary semiconductor switching element is operated with a continuously variable base current or gate voltage; and
    a higher level control unit arranged in communication with the or each local control unit and programmed to selectively implement:

    (i) a first model based control methodology to collectively operate via the or each local control unit each auxiliary semiconductor switching element in the fully-on mode; and
    (ii) a second active control based control methodology to selectively and collectively operate via the or each local control unit each auxiliary semiconductor switching element in one or both of the pulsed switched mode and the active mode.

2. A semiconductor switching string according to Claim 1 wherein having the higher level control unit programmed to selectively implement a first model based control methodology includes having the higher level control unit programmed to establish when each main semiconductor switching element turns off and upon turn off of a respective main semiconductor switching element thereafter operate the corresponding auxiliary semiconductor switching element in its fully-on mode for a first time period.

3. A semiconductor switching string according to Claim 2 wherein having the higher level control unit programmed to establish when each main semiconductor switching element turns off includes detecting when a given main semiconductor switching element turns off by comparing the voltage thereacross with the voltage across an adjacent main semiconductor switching element.

4. A semiconductor switching string according to Claim 3 wherein comparing the voltage across a given main semiconductor switching element with the voltage across an adjacent main semiconductor switching element includes measuring the difference between the voltages and initiating operation of the auxiliary semiconductor switching element corresponding to the given main semiconductor switching element in its fully-on mode when the difference between the voltages exceeds a voltage threshold.

5. A semiconductor switching string according to Claim 2 wherein having the higher level control unit programmed to establish when each main semiconductor switching element turns off includes estimating when a given main semiconductor switching element turns off according to the time elapsed since it was turned on.

6. A semiconductor switching string according to Claim 5 wherein estimating when a given main semiconductor switching element turns off includes initiating operation in its fully-on mode of the corresponding auxiliary semiconductor switching element at the estimated turn off time.

7. A semiconductor switching string according to any of Claims 2 to 5 wherein having the higher level control unit programmed to operate a corresponding auxiliary semiconductor switching element in its fully-on mode for a first time period includes pre-calculating the length of the first time period.

8. A semiconductor switching string according to Claim 7 wherein pre-calculating the length of the first time period includes establishing a transfer function representative of the voltage transfer characteristics of the semiconductor switching string when operating in a blocking mode within in a limb portion of a converter limb in a power converter, with all main semiconductor switching elements in the semiconductor switching string turned off.

9. A semiconductor switching string according to Claim 8 wherein establishing a transfer function includes considering the time response of the transfer function and the associated time constant with a dominant effect on a voltage overshoot of the semiconductor switching string.

10. A semiconductor switching string according to any preceding claim wherein having the higher level control unit programmed to selectively implement a second active control based control methodology includes having the higher level control unit programmed to minimise the deviation of a measured characteristic associated with each main semiconductor switching element from a desired parameter.

11. A semiconductor switching string according to Claim 10 wherein having the higher level control unit programmed to minimise the deviation of a measured characteristic associated with each main semiconductor switching element from a desired parameter includes, for each main semiconductor switching element, generating an error signal representative of the deviation, regulating the error signal to compensate for the deviation and thereby produce a control signal, and generating a switching signal from the control signal to operate the corresponding auxiliary semiconductor switching element in one or both of the pulsed mode and the active mode.

12. A semiconductor switching string according to Claim 11 wherein generating an error signal includes comparing the voltage across each main semiconductor switching element against a desired value.

13. A semiconductor switching string according to Claim 12 wherein the desired value is one of:

> an average of the voltage across a given main semiconductor switching element and the voltage across an adjacent main semiconductor switching element;
> an average of the voltage across all main semiconductor switching elements in the semiconductor switching string; and
> an estimated voltage.

14. A semiconductor switching string according to any of Claims 11 to 13 wherein regulating the error signal includes amplifying the error signal in a proportional manner.

15. A semiconductor switching string according to any of Claims 11 to 14 wherein generating a switching signal from the control signal includes one of:

utilising pulse-width modulation of constant or varying switching frequency; and
scaling the control signal.

**Figure 1**

**Figure 2**

Figure 3

**Figure 4**

**Figure 5**

**Figure 6**

**Figure 7(a)**

**Figure 7(b)**

Europäisches
Patentamt

European
Patent Office

Office européen
des brevets

**EUROPEAN SEARCH REPORT**

Application Number

EP 15 27 5059

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 0 967 721 A2 (TOSHIBA KK [JP]) 29 December 1999 (1999-12-29) | 1,2,7 | INV. H03K17/0814 |
| A | * paragraph [0041]; figures 7-9 * | 3-6,8-15 | H02M1/088 H02M1/34 |
| Y | US 2008/074816 A1 (OMARU TAKESHI [JP]) 27 March 2008 (2008-03-27) | 1,2,7 | H03K17/10 |
| A | * paragraph [0023] - paragraph [0049]; figures 1-3 * | 3-6,8-15 | |
| A | US 2009/085656 A1 (HAVANUR SANJAY [US]) 2 April 2009 (2009-04-02) * paragraph [0052]; figures 2-4 * * paragraph [0058] * | 1-15 | |
| A | US 5 923 513 A (PELLY BRIAN [US]) 13 July 1999 (1999-07-13) * abstract; figure 2 * | 1-15 | |
| A | WO 2014/198730 A1 (ALSTOM TECHNOLOGY LTD [CH]) 18 December 2014 (2014-12-18) * abstract; figure 1 * | 1-15 | |
| | | | TECHNICAL FIELDS SEARCHED (IPC) |
| A | EP 2 445 110 A1 (ABB RESEARCH LTD [CH]) 25 April 2012 (2012-04-25) * abstract; figure 2 * | 1-15 | H03K H02M |

The present search report has been drawn up for all claims

| Place of search | Date of completion of the search | Examiner |
|---|---|---|
| The Hague | 11 August 2015 | Loiseau, Ludovic |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 15 27 5059

This annex lists the patent family members relating to the patent documents cited in the above-mentioned European search report.
The members are as contained in the European Patent Office EDP file on
The European Patent Office is in no way liable for these particulars which are merely given for the purpose of information.

11-08-2015

| Patent document cited in search report | | Publication date | Patent family member(s) | | Publication date |
|---|---|---|---|---|---|
| EP 0967721 | A2 | 29-12-1999 | EP 0967721 A2 | | 29-12-1999 |
| | | | JP 2000012780 A | | 14-01-2000 |
| | | | KR 20000006447 A | | 25-01-2000 |
| | | | US 6268990 B1 | | 31-07-2001 |
| US 2008074816 | A1 | 27-03-2008 | CN 101154880 A | | 02-04-2008 |
| | | | DE 102007019524 A1 | | 10-04-2008 |
| | | | JP 4675302 B2 | | 20-04-2011 |
| | | | JP 2008079475 A | | 03-04-2008 |
| | | | US 2008074816 A1 | | 27-03-2008 |
| US 2009085656 | A1 | 02-04-2009 | CN 101425746 A | | 06-05-2009 |
| | | | TW 200915038 A | | 01-04-2009 |
| | | | US 2009085656 A1 | | 02-04-2009 |
| | | | US 2009243715 A1 | | 01-10-2009 |
| US 5923513 | A | 13-07-1999 | NONE | | |
| WO 2014198730 | A1 | 18-12-2014 | WO 2014198730 A1 | | 18-12-2014 |
| | | | WO 2014198734 A1 | | 18-12-2014 |
| EP 2445110 | A1 | 25-04-2012 | CN 102545859 A | | 04-07-2012 |
| | | | EP 2445110 A1 | | 25-04-2012 |
| | | | US 2012098577 A1 | | 26-04-2012 |
| | | | US 2013328599 A1 | | 12-12-2013 |

EPO FORM P0459

For more details about this annex : see Official Journal of the European Patent Office, No. 12/82